# EUROPÄISCHE PATENTSCHRIFT

(11) **EP 1 598 853 B1**
(45) Veröffentlichungstag und Bekanntmachung des Hinweises auf die Patenterteilung: **25.04.2007**
(21) Anmeldenummer: 05003977.5
(22) Anmeldetag: 24.02.2005
(51) Int. Cl.: H01L 21/00, H01L 21/68, G03F 7/20

(54) **Justiereinrichtung für Wafer**
Adjustment apparatus for wafers
Appareil à ajuster de wafers

(30) Priorität: 18.05.2004 DE 102004024649
(43) Veröffentlichungstag der Anmeldung: 23.11.2005
(73) Patentinhaber: Thallner, Erich, Dipl.-Ing., 4782 St. Florian (AT)
(72) Erfinder: Thallner, Erich, Dipl.-Ing., 4782 St. Florian (AT)
(74) Vertreter: Schweiger, Johannes

(56) Entgegenhaltungen:
- GB-A- 21 070 651
- US-A- 4 922 277
- US-A- 5 549 756
- US-A1- 2002 113 056
- US-B1- 6 299 713
- PATENT ABSTRACTS OF JAPAN Bd. 008, Nr. 049 (E-230), 6. März 1984 (1984-03-06) -& JP 58 202543 A (MITSUBISHI DENKI KK), 25. November 1983 (1983-11-25)

## Beschreibung

Die Erfindung betrifft eine Justiereinrichtung mit einer Aufnahmeeinrichtung zur Aufnahme eines Wafers auf eine Aufnahmeseite der Aufnahmeeinrichtung, wobei die Aufnahmeeinrichtung mindestens eine im wesentlichen orthogonal zur Aufnahmeseite gerichtete Durchtrittsöffnung aufweist. Die Erfindung betrifft weiterhin eine Vorrichtung zum Justieren eines Wafers mit einer solchen Justiereinrichtung.

Solche Justiereinrichtungen werden beispielsweise in einem Bondwerkzeug für Infrarotjustierungen verwendet. Die Bondwerkzeuge, die auch als Bond Chucks bezeichnet werden, werden dazu verwendet, um Wafer optisch anhand von Passmarken im Wafer zu justieren und nachfolgend den justierten Waferstapel in einen Waferbonder zu übertragen.

Die Justierung wird beispielsweise mit Infrarotbeleuchtung durchgeführt und erfordert Ausschnitte im Bond Chuck/Bondwerkzeug zur Durchleuchtung des Wafers zu einer gegenüberliegenden Erfassungseinrichtung, beispielsweise ein Mikroskop.

Die Justiereinrichtung wird am Bond Chuck fixiert und anschließend wird der Wafer anhand der Passmarken genau ausgerichtet.

Nach Transfer des Bond Chucks in den Waferbonder wird unter Anwendung von mechanischem Druck und Temperatur eine permanente Verbindung hergestellt. Die Verbindung der Wafer kann über Klebeschichten (Polymer), Metalle (z. B. Cu-Cu diffusionsbonden) oder Metalllegierungen (z. B. CuSn eutektische Lötlegierung) hergestellt werden.

Die Ausschnitte werden in die Bond Chucks nach der Herstellung der Bond Chucks eingebracht. Dabei tritt das Problem auf, dass es auf der einen Seite notwendig ist, einen genügend großen Ausschnitt vorzusehen, um eine hohe Lichtausbeute beim Durchtritt durch den Ausschnitt zu erhalten. Des weiteren ist die Fertigung von Ausschnitten mit sehr geringem Durchmesser in den etwa 8 mm dicken Bond Chucks technisch problematisch. Auf der anderen Seite tritt jedoch bei der Aufbringung von Kontaktkraft auf den Wafer z. B. beim Thermokompressionsbondverfahren über dem Ausschnitt des Bond Chucks eine Druckungleichmäßigkeit auf, die um so größer ist, je größer der Durchmesser des Ausschnittes ist. Die Ausschnittsfläche hinterlässt dadurch eine Fehlstelle im Bond Interface. Mit Bond Interface ist die Verbindung zwischen den Scheiben des Wafers gemeint.

Ein Positioniermechanismus für Halbleitersubstrate ist beispielsweise jeweils in der JP 58202543 A und in dem Dokument GB 2170651 A gezeigt.

Aufgabe der vorliegenden Erfindung gemäß dem Anspruch 1 ist es daher, eine Justiereinrichtung vorzusehen, mit der gleichzeitig Fehlstellen minimiert bzw. eliminiert werden und deren Fertigung günstiger ist.

Grundidee der Erfindung ist es, die Justiereinrichtung im Ausschnitt symmetrisch so anzupassen, dass auf der Kontaktseite des Bond Chucks mit dem Wafer eine möglichst geringe Ausschnittsfläche mit genügendem Lichtdurchlass und auf der anderen Seite eine fertigungstechnisch leicht herzustellende größere Ausschnittsfläche vorgesehen ist.

Soweit im Zusammenhang mit der Erfindung von Wafer gesprochen wird, steht dies stellvertretend für jede Art eines Flächenbauteils, das mit einem flächigen Verbindungselement genau kontaktiert werden muss.

In ihrer allgemeinsten Ausführungsform betrifft die Erfindung eine Justiereinrichtung mit einer Aufnahmeeinrichtung zur Aufnahme eines Wafers auf eine Aufnahmeseite der Aufnahmeeinrichtung, wobei die Aufnahmeeinrichtung mindestens eine im wesentlichen orthogonal zur Aufnahmeseite gerichtete Durchtrittsöffnung aufweist, die auf der Aufnahmeseite einen kleineren Querschnitt aufweist als auf der der Aufnahmeseite abgewandten Eintrittsseite der Durchtrittsöffnung. Die Durchtrittsöffnung ist als Lichtdurchtrittsöffnung ausgestaltet.

Die Aufnahmeeinrichtung kann ein Bond Chuck sein, der den Wafer aufnimmt und diesen gegebenenfalls mit Klammern fixiert. Durch den kleineren Querschnitt auf der Aufnahmeseite wird je nach Größe des Querschnitts verhindert, dass Fehlstellen in dem Bond Interface nach Aufbringen einer Druckkraft an der Stelle der Durchtrittsöffnung auftreten. Dennoch ist sichergestellt, dass die Fertigung der Durchtrittsöffnung - beispielsweise durch Bohren - von der Eintrittsseite aus und des größeren Querschnitts von der Eintrittsseite aus stark vereinfacht wird.

In einer Ausgestaltung der Erfindung ist die Durchtrittsöffnung so ausgestaltet, dass sie einen ersten Abschnitt aufweist, der sich von der Aufnahmeseite in die Durchtrittsöffnung hineinerstreckt und dessen Innenwandung im wesentlichen parallel zur Mittelachse der Durchtrittsöffnung verläuft. Durch diese Maßnahme wird die Stabilität der aufnahmeseitigen Durchtrittsöffnung bei angelegter Druckkraft gewährleistet. Darüber hinaus wird dadurch erreicht, dass der durch die Durchtrittsöffnung durchtretende Lichtstrahl gebündelt wird und eine Brechung des Lichts minimiert wird. Der kleinste Durchmesser des ersten Abschnitts der Durchtrittsöffnung kann < 7 mm, insbesondere < 5 mm, vorzugsweise < 3 mm und noch bevorzugter < 1 mm sein.

In einer weiteren Ausgestaltung der Erfindung ist vorgesehen, dass die Durchtrittsöffnung einen zweiten Abschnitt aufweist, der sich von dem ersten Abschnitt bis zur Eintrittsseite erstreckt, wobei der Querschnitt des zweiten Abschnitts bis zur Eintrittsseite vorzugsweise konisch zunimmt. Durch diese Ausgestaltung wird erreicht, dass das auf dieser Seite eintretende Licht gebündelt wird und sich die Fertigung der Durchtrittsöffnung auf dieser Seite wesentlich einfacher gestaltet.

Die Durchtrittsöffnung kann im Querschnitt schlitzförmig oder rund ausgebildet sein. Bei einer schlitzförmigen Ausgestaltung ist die Lichtausbeute höher und die Positionierung gestaltet sich etwas einfacher, wohingegen die runde Ausgestaltung leichter zu fertigen ist.

Es ist weiterhin vorgesehen, dass die Aufnahmeeinrichtung im wesentlichen scheibenförmig ist und zwei in der Mittelachse der Aufnahmeeinrichtung angeordnete schlitzförmige Durchtrittsöffnungen aufweist. Dabei kann die Durchtrittsöffnung 2 - 12 mm, vorzugsweise jedoch 8 mm tief sein. Dies entspricht im wesentlichen der Dicke der Aufnahmeeinrichtung, da die Mittelachse der Durchtrittsöffnung im wesentlichen orthogonal zur Aufnahmeseite der Aufnahmeeinrichtung ist. Darin erstreckt sich der erste Abschnitt von der Aufnahmeseite in die Durchtrittsöffnung und endet nach 0,1 mm - 5 mm, jedoch vorzugsweise nach 1 mm. Daran schließt sich der zweite Abschnitt an, der sich bis zum Ende der Durchtrittsöffnung, d. h. bis zur Eintrittseite erstreckt. Besonders leicht zu fertigen ist eine konische Erweiterung, die in einem Winkel von 70° - 120°, vorzugsweise 90° verläuft. Gleichzeitig wird durch diese konische Erweiterung erreicht, dass das Eintreten des Lichts gebündelt und in Richtung des ersten Abschnitts geleitet wird.

Die Eigenschaften der Justiereinrichtung werden dadurch verbessert, dass die Aufnahmeeinrichtung aus Siliziumkarbid besteht. Alternativ kann sie auch aus Titan bestehen. Diese Werkstoffe sind zu bevorzugen, da die Ebenheitstoleranz der Vorder- und Rückseite des Bond Chucks/der Aufnahmeeinrichtung besser als bei rostfreien Stahllegierungen ist. Dadurch wird das Bondergebnis nochmals deutlich verbessert.

Die Erfindung betrifft auch eine Vorrichtung zum Justieren eines Wafers mit einer solchen Justiereinrichtung, wobei Licht, insbesondere Infrarotlicht durch die Durchtrittsöffnung über eine in dem Wafer integrierte Struktur auf eine optische Erfassungseinrichtung trifft und Mittel zur Ausrichtung des Wafers basierend auf den Erfassungsparametern vorgesehen sind.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert. Die darin beschriebenen Merkmale können sowohl einzeln als auch in beliebigen Kombinationen für die Verwirklichung der Erfindung von Bedeutung sein. Dies gilt auch für die Merkmale die vorstehend zur Beschreibung der Vorrichtung und der Justiereinrichtung genannt wurden. Die Figuren der Zeichnung zeigen im einzelnen:
- Fig. 1: eine geschnittene Seitenansicht der erfindungsgemäßen Vorrichtung;
- Fig. 2: eine Seitenansicht der Justiereinrichtung;
- Fig. 3: eine Aufsicht auf die Justiereinrichtung;
- Fig. 4: eine geschnittene Seitenansicht der Justiereinrichtung gemäß Schnittlinie A-A aus Figur 3.

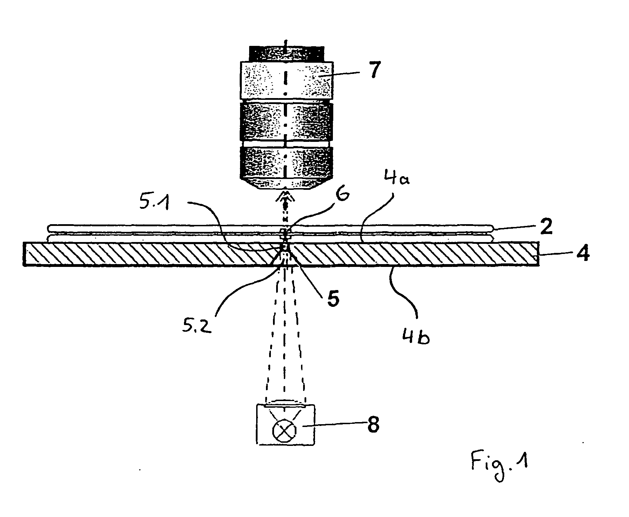

In Figur 1 ist eine Lichtquelle 8 für infrarotes Licht dargestellt, die Infrarotlicht durch die Durchtrittsöffnung 5 der Justiereinrichtung schickt und vorzugsweise genau unterhalb der jeweiligen Durchtrittsöffnung 5 angeordnet ist. Je nachdem, wie viele Durchtrittsöffnungen 5 in der Aufnahmeeinrichtung 4 enthalten sind, kann für jede Durchtrittsöffnung 5 je eine Lichtquelle 8 angeordnet sein. Es kann jedoch über nicht dargestellte Umlenkspiegel mit Hilfe einer Lichtquelle 8 Licht zu mehreren Durchtrittsöffnungen 5 der Aufnahmeeinrichtung 4 gesendet werden. Auf der Aufnahmeseite 4a der Aufnahmeeinrichtung 4 liegt der Wafer 2, der aus zu verbindenden Substraten oder Scheiben, beispielsweise Si (Silizium) - Wafer oder Verbundhalbleitermaterialien besteht, auch als Bond Interface bezeichnet. Die untere Seite der Aufnahmeeinrichtung 4 ist als Eintrittsseite 4b für das Licht aus der Lichtquelle 8 bezeichnet.

Über dem Wafer 2 und in Verlängerung des durch die Durchtrittsöffnung 5 und den Wafer 2 tretenden Lichtstrahls ist eine optische Erfassungseinrichtung 7 angeordnet, die beispielsweise ein Mikroskop zum mikrometergenauen Ausrichten der beiden Wafer zueinander ist. Je nachdem, wie viele Durchtrittsöffnungen 5 vorgesehen sind, können für jede Durchtrittsöffnung 5 wiederum Mikroskope 7 vorgesehen sein. Alternativ kann auch hier die Erfassung über Umlenkspiegel oder ähnliche Einrichtungen erfolgen.

Die Erfassung der Relativposition der zu verbindenden Substrate oder Scheiben der Wafer 2 zueinander erfolgt durch gegenüberliegende Strukturen in den Wafern, anhand derer eine mikrometergenaue Ausrichtung der Wafer 2 über die Mikroskope 7 möglich ist. Als solche Strukturen sind Passmarken 6 vorgesehen, die beispielsweise ein Muster beinhalten, das in den zu verbindenden Substraten enthalten ist und das zur Ausrichtung durch die Mikroskope und eine nicht dargestellte Verschiebeeinrichtung dient, die über eine ebenfalls nicht gezeigte Steuereinrichtung gesteuert werden.

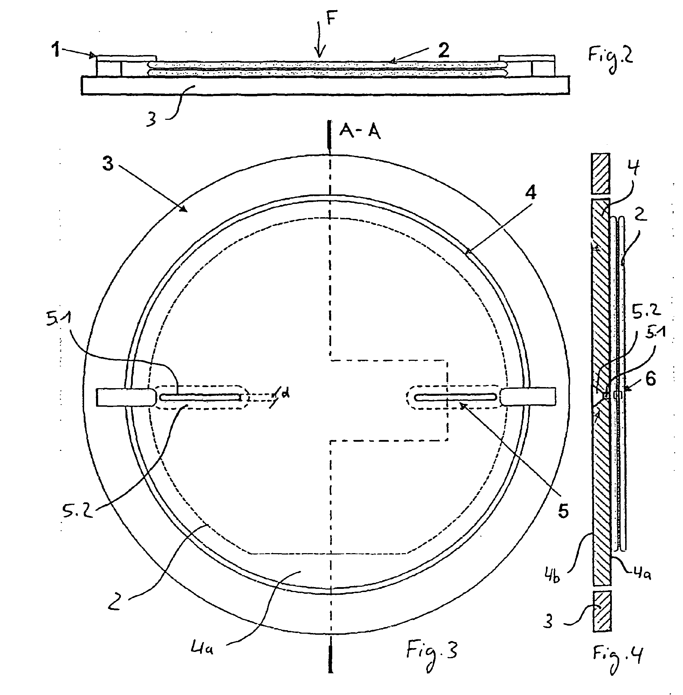

In den Figuren 2, 3 und 4 ist zu erkennen, dass die Aufnahmeeinrichtung 4 in einem Aufnahmerahmen 3 zur Aufnahme der Aufnahmeeinrichtung 4 eingesetzt ist. Federbelastete Klammern 1 dienen zur mechanischen Fixierung nach der Justierung, so dass der justierte Wafer 2 zusammen mit dem Bond Chuck/der Aufnahmeeinrichtung 4 weiteren Behandlungsschritten zugeführt werden kann, ohne zu verrutschen.

In den Figuren 1, 3 und 4 sind die Durchtrittsöffnungen 5 dargestellt. Diese sind jeweils unterteilt in einen ersten Abschnitt 5.1, der sich von der Aufnahmeseite 4a in die Durchtrittsöffnung 5 hinein erstreckt. Daran schließt sich der zweite Abschnitt 5.2 an, der sich bis zur Eintrittsseite 4b des Lichtes aus der Lichtquelle 8 erstreckt. In der Aufsicht der Figur 3 ist zu erkennen, dass die Durchtrittsöffnung als Schlitz ausgebildet ist. Alternativ kann die Durchtrittsöffnung auch rund ausgestaltet sein.

Die jeweils gegenüberliegenden Innenwände des ersten Abschnitts 5.1 der Durchtrittsöffnung 5 verlaufen parallel zueinander. Die Innenwände des zweiten Abschnitts 5.2 verlaufen von dem ersten Abschnitt 5.1 konisch erweiternd bis zu der Eintrittsseite 4b. Dabei ist am Übergang vom ersten Abschnitt 5.1 zum zweiten Abschnitt 5.2 keine Stufe vorgesehen, da anderenfalls eine Reflektierung des Lichts aus der Lichtquelle 8 erfolgt.

Wird der Wafer nach der Justierung mit der erfindungsgemäßen Vorrichtung bzw. Justiereinrichtung zusammen mit dem Bond Chuck 4 in einem weiteren Verfahrensschritt mit einer Kraft F - dargestellt in Figur 2 durch den Pfeil - beaufschlagt, ist durch die erfindungsgemäße Ausgestaltung der Durchtrittsöffnung 5 die Stelle, an der der Wafer keine Gegenkraft durch den Bond Chuck 4 erfährt, so klein, dass keine Fehlstellen mehr auftreten. Diese Verfahrensschritte und damit Probleme treten beispielsweise bei Termokompressions-Verfahren auf, bei welchen beispielsweise Bonds mit Polymerkleber (z. B. BCB Dow Corning, SU-8 Microchem), eutektische Bonderbindungen (z. B. Au-Si, Cu-Sn) oder Metall Diffusionsbonds (z.B. Au-Au, Cu-Cu) eingesetzt werden.

Die Größe der Durchtrittsöffnung 5 bzw. der Querschnitt der Durchtrittsöffnung 5 ergibt sich je nach Dicke der Wafer 2. Standard Waferdicken sind beispielsweise 380 - 750 µm. Bei den Standard Waferdicken haben sich Durchmesser von ca. 5 mm für die Durchtrittsöffnung 5 bewährt, wenn die Durchtrittsöffnung 5 rund ist und 10 mm, wenn sie als Schlitz ausgebildet ist. Bei diesen Ausgestaltungen ist jedoch eine Druckungleichmäßigkeit im Bereich der Durchtrittöffnung unvermeidbar. Durch die vorliegende Erfindung wird die Möglichkeit gegeben, die Durchtrittsöffnung 5 bis auf 0,1 mm zu verkleinern. Ein ausgewogenes Verhältnis der Herstellungskosten bei Vermeidung von Fehlstellen durch Druckbeaufschlagung wird mit einem Querschnitt von 1 mm, einer Tiefe des ersten Abschnitts 5.1 von 1 mm und einer Tiefe des zweiten Abschnitts von 7 mm und einem Eröffnungswinkel des zweiten Abschnitts 5.2 von 90° erreicht.

Die konische Erweiterung des zweiten Abschnitts 5.2 verleiht der Aufnahmeeinrichtung 4 eine hohe Steifigkeit um die Durchtrittsöffnung 5 herum. Eine tiefe zylindrische Ansenkung würde das Material um die Durchtrittsöffnung 5 herum schwächen und eine Ungleichmäßigkeit der Druckverteilung zur Folge haben.

## Patentansprüche

1. Justiereinrichtung zum Justieren eines Wafers mit einer Aufnahmeeinrichtung (4) zur Aufnahme eines Wafers (2) auf einer Aufnahmeseite (4a) der Aufnahmeeeinrichtung (4), wobei die Aufnahmeeeinrichtung (4) mindestens eine im wesentlichen orthogonal zur Aufnahmeseite (4a) gerichtete Lichtdurchtrittsöffnung (5) aufweist,
**dadurch gekennzeichnet, dass**
die Lichtdurchtrittsöffnung (5) für durchtretende Lichtstrahlen auf der Aufnahmeseite (4a) einen kleineren Querschnitt aufweist als auf der der Aufnahmeseite (4a) abgewandten Lichteintrittsseite (4b) der Lichtdurchtrittsöffnung (5).

2. Justiereinrichtung nach Anspruch 1, **dadurch gekennzeichnet, dass** die Lichtdurchtrittsöffnung (5) einen ersten Abschnitt (5.1) aufweist, der sich von der Aufnahmeseite (4a) in die Lichtdurchtrittsöffnung (5) hinein erstreckt und dessen Innenwandung im wesentlichen parallel zur Mittelachse der Lichtdurchtrittsöffnung (5) verläuft.

3. Justiereinrichtung nach Anspruch 2, **dadurch gekennzeichnet, dass** der kleinste Durchmesser (d) des ersten Abschnitts (5.1) der Lichtdurchtrittsöffnung (5) kleiner als 7 mm, insbesondere kleiner als 5 mm, vorzugsweise kleiner als 3 mm ist, noch bevorzugter kleiner als 1 mm ist.

4. Justiereinrichtung nach Anspruch 2 oder 3, **dadurch gekennzeichnet, dass** die Lichtdurchtrittsöffnung (5) einen zweiten Abschnitt (5.2) aufweist, der sich von dem ersten Abschnitt (5.1) bis zur Lichteintrittsseite (4b) erstreckt, wobei der Querschnitt des zweiten Abschnitts (5.2) bis zur Lichteintrittsseite (4b), vorzugsweise konisch, zunimmt.

5. Justiereinrichtung nach Anspruch 1, **dadurch gekennzeichnet, dass** der Querschnitt der Lichtdurchtrittsöffnung (5) schlitzförmig ausgebildet ist.

6. Justiereinrichtung nach Anspruch 1, **dadurch gekennzeichnet, dass** der Querschnitt der Lichtdurchtrittsöffnung (5) rund ausgebildet ist.

7. Justiereinrichtung nach Anspruch 1, **dadurch gekennzeichnet, dass** die Aufnahmeeinrichtung (4) im wesentlichen scheibenförmig ist und zwei in der Mittelachse der Aufnahmeeinrichtung (4) angeordnete, schlitzförmige Lichtdurchtrittsöffnungen (5) aufweist.

8. Justiereinrichtung nach Anspruch 1, **dadurch gekennzeichnet, dass** die Lichtdurchtrittsöffnung (5) 2 bis 12 mm, vorzugsweise 8 mm, tief ist,

9. Justiereinrichtung nach Anspruch 1, **dadurch gekennzeichnet, dass** der erste Abschnitt (5.1) sich von der Aufnahmeseite (4a) um 0,1 mm bis 5 mm, vorzugsweise 1 mm, in die Lichtdurchtrittsöffnung (5) erstreckt.

10. Justiereinrichtung nach Anspruch 1, **dadurch gekennzeichnet, dass** der zweite Abschnitt (5.2) sich von dem erste Abschnitt (5.1) bis zur Lichteintrittsseite (4b) erstreckt und in einem Winkel von 70° bis 120°, vorzugsweise 90°, bis zur Lichteintrittsseite (4b) konisch erweiternd verläuft.

11. Justiereinrichtung nach Anspruch 1, **dadurch gekennzeichnet, dass** die Aufnahmeeinrichtung (4) aus Siliziumkarbid besteht.

12. Justiereinrichtung nach Anspruch 1, **dadurch gekennzeichnet, dass** die Aufnahmeeinrichtung (4) aus Titan besteht.

13. Vorrichtung zum Justieren eines Wafers (2) mit einer Einrichtung nach einem der vorhergehenden Ansprüche, wobei Licht, insbesondere Infrarot-Licht, durch die Lichtdurchtrittsöffnung (5) über eine in dem Wafer integrierte Struktur auf eine optische Erfassungseinrichtung (7) trifft und Mittel zur Ausrichtung des Wafers (2) basierend auf den Erfassungsparametern, vorgesehen sind.

## Claims

1. Adjusting device for adjusting a wafer with a holding device (4) for holding a wafer (2) on a holding side (4a) of the holding device (4), wherein the holding device (4) has at least one light through-opening (5) which is directed substantially orthogonally to the holding side (4a),
**characterised in that**
the light through-opening (5) for light beams passing through has a smaller cross section on the holding side (4a) than on the light entrance side (4b), which is remote from the holding side (4a), of the light through-opening (5).

2. Adjusting device according to Claim 1, **characterised in that** the light through-opening (5) has a first portion (5.1) which extends from the holding side (4a) into the light through-opening (5) and the inner wall of which runs substantially parallel to the centre axis of the light through-opening (5).

3. Adjusting device according to Claim 2, **characterised in that** the smallest diameter (d) of the first portion (5.1) of the light through-opening (5) is smaller than 7 mm, in particular smaller than 5 mm, preferably smaller than 3 mm, more preferably smaller than 1 mm.

4. Adjusting device according to Claim 2 or 3, **characterised in that** the light through-opening (5) has a second portion (5.2) which extends from the first portion (5.1) up to the light entrance side (4b), wherein the cross section of the second portion (5.2) increases, preferably conically, up to the light entrance side (4b).

5. Adjusting device according to Claim 1, **characterised in that** the cross section of the light through-opening (5) is slot-shaped.

6. Adjusting device according to Claim 1, **characterised in that** the cross section of the light through-opening (5) is round.

7. Adjusting device according to Claim 1, **characterised in that** the holding device (4) is substantially disc-shaped and has two slot-shaped light through-openings (5) disposed at the centre axis of the holding device (4).

8. Adjusting device according to Claim 1, **characterised in that** the light through-opening (5) is 2 - 12 mm, preferably 8 mm, deep.

9. Adjusting device according to Claim 1, **characterised in that** the first portion (5.1) extends from the holding side (4a) by 0.1 mm to 5 mm, preferably 1 mm, into the light through-opening (5).

10. Adjusting device according to Claim 1, **characterised in that** the second portion (5.2) extends from the first portion (5.1) up to the light entrance side (4b) and runs in a conically widening manner at an angle of 70° to 120°, preferably 90°, up to the light entrance side (4b).

11. Adjusting device according to Claim 1, **characterised in that** the holding device (4) consists of silicon carbide.

12. Adjusting device according to Claim 1, **characterised in that** the holding device (4) consists of titanium.

13. Apparatus for adjusting a wafer (2) with a device according to any one of the preceding Claims, wherein light, in particular infrared light, impinges on an optical detection device (7) through the light through-opening (5) by way of a structure integrated in the wafer and means are provided for aligning the wafer (2) on the basis of the detection parameters.

## Revendications

1. Dispositif d'ajustage pour ajuster une tranche de silicium ayant un dispositif de réception (4) pour recevoir une tranche de silicium (2) sur un côté de réception (4a) du dispositif de réception (4), où le dispositif de réception (4) présente au moins une ouverture de passage de lumière (5) orientée sensiblement perpendiculairement au côté de réception (4a), **caractérisé en ce que** l'ouverture de passage de lumière (5) présente pour les rayons lumineux la traversant une plus petite section sur le côté de réception (4a) que sur le côté de pénétration de la lumière (4b) de l'ouverture de passage de lumière (5) opposé au côté de réception (4a).

2. Dispositif d'ajustage selon la revendication 1, **caractérisé en ce que** l'ouverture de passage de lumière (5) présente une première portion (5.1) qui s'étend depuis le côté de réception (4a) jusqu'à l'intérieur de l'ouverture de passage de lumière (5) et dont la paroi intérieure s'étend sensiblement parallèlement à l'axe central de l'ouverture de passage de lumière (5).

3. Dispositif d'ajustage selon la revendication 2, **caractérisé en ce que** le plus petit diamètre (d) de la première portion (5.1) de l'ouverture de passage de lumière (5) est inférieur à 7 mm, en particulier inférieur à 5 mm, de préférence inférieur à 3 mm, et de préférence encore inférieur à 1 mm.

4. Dispositif d'ajustage selon la revendication 2 ou 3, **caractérisé en ce que** l'ouverture de passage de lumière (5) présente une deuxième portion (5.2) qui s'étend depuis la première portion (5.1) jusqu'au côté de pénétration de la lumière (4b), sachant que la section de la deuxième portion (5.2) augmente, de préférence de façon conique, en direction du côté de pénétration de la lumière (4b).

5. Dispositif d'ajustage selon la revendication 1, **caractérisé en ce que** la section de l'ouverture de passage de lumière (5) est conçue en forme de fente.

6. Dispositif d'ajustage selon la revendication 1, **caractérisé en ce que** la section de l'ouverture de passage de lumière (5) est conçue en forme circulaire.

7. Dispositif d'ajustage selon la revendication 1, **caractérisé en ce que** le dispositif de réception (4) est essentiellement en forme de disque et présente deux ouvertures de passage de lumière (5) en forme de fentes agencées dans l'axe central du dispositif de réception (4).

8. Dispositif d'ajustage selon la revendication 1, **caractérisé en ce que** l'ouverture de passage de lumière (5) a une profondeur de 2 à 12 mm, de préférence de 8 mm.

9. Dispositif d'ajustage selon la revendication 1, **caractérisé en ce que** la première portion (5.1) s'étend dans l'ouverture de passage de lumière (5) à partir du côté de réception (4a) de 0,1 mm à 5 mm, de préférence de 1 mm.

10. Dispositif d'ajustage selon la revendication 1, **caractérisé en ce que** la deuxième portion (5.2) s'étend depuis la première portion (5.1) jusqu'au côté de pénétration de la lumière (4b) et s'étend en s'élargissant de façon conique dans un angle de 70° à 120°, de préférence 90°, jusqu'au côté de pénétration de la lumière (4b).

11. Dispositif d'ajustage selon la revendication 1, **caractérisé en ce que** le dispositif de réception (4) est constitué de carbure de silicium.

12. Dispositif d'ajustage selon la revendication 1, **caractérisé en ce que** le dispositif de réception (4) est constitué de titane.

13. Système d'ajustage d'une tranche de silicium (2) avec un dispositif selon l'une quelconque des revendications précédentes, dans lequel une lumière, en particulier une lumière infrarouge, passant à travers l'ouverture de passage de lumière (5) par le biais d'une structure intégrée dans la tranche de silicium, rencontre un dispositif de saisie optique (7) et des moyens sont prévus pour orienter la tranche de silicium (2) sur la base des paramètres de la saisie.
